# EUROPÄISCHE PATENTANMELDUNG

(11) **EP 4 270 037 A1**
(43) Veröffentlichungstag der Anmeldung: **01.11.2023**
(21) Anmeldenummer: 22170506.4
(22) Anmeldetag: 28.04.2022
(51) Int. Cl.: G01R 33/36

(54) **PLANARE INDUKTIVE KOPPLER ALS TRENNBARE STECKVERBINDUNGEN FÜR EINEN MAGNETRESONANZTOMOGRAPHEN**

(71) Anmelder: Siemens Healthcare GmbH, 91052 Erlangen (DE)
(72) Erfinder: Bollenbeck, Jan, 91330 Eggolsheim (DE); Pfister, Jakob, 91330 Eggolsheim (DE)

(57) **Zusammenfassung**

Die Erfindung betrifft eine Übertragungsvorrichtung sowie einen Magnetresonanztomographen mit einer Übertragungsvorrichtung. Die Übertragungsvorrichtung weist eine Kopplungsvorrichtung mit einem ersten und einem zweiten lösbar in einer vorbestimmten Relativposition zueinander positionierbaren Koppelelementen auf. Das erste Koppelelement und das zweite Koppelelement weisen jeweils eine erste und eine zweite planare Spule auf. In der vorbestimmten Relativposition sind jeweils die erste planare Spule im ersten Koppelelement mit der ersten planaren Spule im zweiten Koppelelement und die zweite planare Spule im ersten Koppelelement mit der zweiten planaren Spule im zweiten Koppelelement zur Übertragung von einem ersten Signal über die ersten planaren Spulen und einem davon in Amplitude, Frequenz und/oder Phase unterschiedlichen zweiten Signal über die zweiten planaren Spulen induktiv gekoppelt.

## Beschreibung

Die Erfindung betrifft eine Übertragungsvorrichtung für einen Magnetresonanztomographen mit einer lösbaren Kopplungsvorrichtung. Die Kopplungsvorrichtung weist induktiv gekoppelte planare Spulen auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden.

Es werden unterschiedliche Lokalspulen für unterschiedliche Körperregionen des Patienten genutzt, um ein möglichst rauscharmes und starkes Signal direkt am Körper aufzunehmen. Es ist deshalb auch häufig notwendig, zwischen Untersuchungen die Lokalspule zu wechseln. Dabei werden die von der Lokalspule aufgenommenen Magnetresonanzsignale üblicherweise über Kabel zu Empfängern des Magnetresonanztomographen geleitet. Um die Lokalspule wechselbar zu gestalten, sind dabei die Kabei über vieladrige Stecker an den Magnetresonanztomographen angeschlossen. Für die Hochfrequenzsignale kommen dabei Koaxial-Kontakte zur Verwendung, die empfindlich auf Beschädigung und Verschmutzung sind. Darüber hinaus ist eine gründliche Reinigung zur Erreichung der notwendigen Sterilität wegen der vorhandenen Vertiefungen und komplexen Oberflächenstruktur des Steckers bzw. der Buchse sehr schwierig.

Es ist daher eine Aufgabe der Erfindung, eine Übertragungsvorrichtung zwischen Lokalspule und Magnetresonanztomograph bereitzustellen, die einfacher handzuhaben ist.

Die Aufgabe wird durch eine erfindungsgemäße Übertragungsvorrichtung nach Anspruch 1 und einen erfindungsgemäßen Magnetresonanztomographen nach Anspruch 10 gelöst.

Die erfindungsgemäße Übertragungsvorrichtung ist für einen Magnetresonanztomographen vorgesehen. Deshalb ist die Übertragungsvorrichtung ausgelegt, bei dem Betrieb des Magnetresonanztomographen auftretenden Signale zu übertragen, insbesondere zwischen einer Lokalspule und dem Magnetresonanztomographen. Die Signale können dabei Magnetresonanzsignale mit einer durch das statische Magnetfeld des Magnetresonanztomographen und die Art der erfassten Kernspins definierten Larmorfrequenz sein, daraus durch Frequenzumsetzung oder Digitalisierung entstandene Signal, oder auch für Verarbeitung der Lokalspule zugeführte Hilfssignale wie ein Referenztakt. Dabei ist die Übertragungsvorrichtung ausgelegt, zumindest zwei unterschiedliche Signale gleichzeitig zu übertragen, seien es zwei Magnetresonanzsignale unterschiedlicher Antennenspulen oder Magnetresonanzsignal und Hilfssignal.

Die Übertragungsvorrichtung weist eine Kopplungsvorrichtung mit einem ersten Koppelelement und einem zweiten Koppelelement auf. Das erste Koppelelement kann dabei lösbar mit dem zweiten korrespondierenden Koppelelement in einer vorbestimmten Relativposition verbunden werden, beispielsweise durch Formschluss, Kraftschluss und/oder zusätzliche Fixierungselemente. Denkbar sind beispielsweise korrespondierende Rastelemente, Federelemente oder vergleichbares, wie sie auch bei anderen Steckern und Buchsen verwendet werden. Es wäre auch denkbar, dass die Rast- bzw. Fixierungselemente gleichzeitig als galvanische Kontakte beispielsweise für eine Energieversorgung über die Übertragungsvorrichtung dienen. Außerhalb des Untersuchungsbereichs und des statischen Magnetfeldes wären auch Magnete als Haltelement denkbar. Auch Ansaugen mittels Unterdrucks an einer Kontaktfläche oder einem Saugnapf vergleichbare Mechanismen wäre denkbar. Im Gegensatz zu konventionellen Koaxialsteckern sind aber zumindest einer, mehrere oder alle Koaxialkontakte durch induktiv gekoppelte planare Spulen zur Signalübertragung ersetzt. Insbesondere ist Stecker oder Buchse in Bezug auf die erfindungsgemäßen Koppelelemente nicht dahin zu verstehen, dass eines der Koppelelemente notwendigerweise hervorstehende und das andere Koppelelement korrespondierende versenkte Kontaktflächen (auch als männlich oder weiblich bezeichnet) aufweisen.

Das erste Koppelelement und das zweite Koppelelement weisen jeweils eine erste planare Spule und eine zweite planare Spule auf. In der vorbestimmten Relativposition des ersten Koppelelements ist die erste planare Spule des ersten Koppelelements mit der ersten planaren Spule des zweiten Koppelelements induktiv gekoppelt. Das gleiche gilt entsprechend für die zweiten planaren Spulen des ersten und zweiten Koppelelements. Als induktiv gekoppelt wird dabei verstanden, dass eine Signalübertragung zwischen den planaren Spulen in dem ersten und dem zweiten Koppelelementen erfolgen kann, vorzugsweise mit einem Koppelfaktor größer als 0,1, 0,25, 0,5 oder 0,9. Für einen symmetrischen Koppler gibt der Koppelfaktor das Verhältnis von Gegeninduktivität zu Hauptinduktivität an und ist somit ein Maß für das Verhältnis der Stromamplitude in der empfangenen Spule zur Stromamplitude in der emittierenden Spule, die mit einer Signalquelle verbunden ist.

Vorzugsweise weisen die ersten planaren Spulen und die zweiten planaren Spulen keine ferromagnetischen Elemente wie Kerne bzw. Schalenkerne auf, die sonst in Transformatoren Verwendung finden, um die Feldlinien zu bündeln. Derartige Materialien wären im starken statischen B0-Feld des Magnetresonanztomographen gesättigt und damit wirkungslos und/oder würden darüber hinaus die Homogenität des B0-Feldes stören.

Die induktive Kopplung wird erzielt, indem die planare Spule des ersten Koppelelements in geringem Abstand zu der entsprechenden planaren Spule des zweiten Koppelelements in der vorbestimmten Relativposition derart angeordnet wird, sodass eine Projektion der planaren Spule des ersten Koppelelements auf die planaren Spule des zweiten Koppelelements entlang einer Flächennormalen der Fläche, in der die planare Spule angeordnet ist, mit der Fläche der planaren Spule in dem zweiten Koppelelement weitgehend deckungsgleich ist. Als weitgehend deckungsgleich wird es dabei angesehen, wenn der Betrag der Fläche der Schnittmenge größer als 50%, 75% oder 90% des Betrages von der von der planaren Spule eingenommenen Fläche ist. Dabei sind die planaren Spulen des ersten Koppelelements von den korrespondierenden planaren Spulen des zweiten Koppelelements entlang der Flächennormalen weniger als 10mm, 5mm oder 1 mm beabstandet. Der Abstand kann auch in Bezug auf eine minimale Abmessung der planaren Spulen in der von ihr eingenommenen Fläche definiert sein und kleiner als 20%, 10% oder 5% dieser Abmessung sein. Vorzugsweise sind die Abmessungen der beiden induktiv gekoppelten planaren Spulen im Wesentlichen gleich. Vorzugsweise sind dabei die planare Spule in dem ersten Koppelelement und in dem zweiten Koppelelement zueinander parallel oder unter einem von den durch die planaren Spulen eingenommenen Flächen eingeschlossenen Winkel kleiner als 20 Grad, 10 Grad oder 5 Grad angeordnet.

Die Kopplungsvorrichtung ist ausgelegt, mittels der induktiven Kopplung zwei unterschiedliche Signale mit unterschiedlicher Amplitude und/oder Frequenz und/oder Phase über die ersten planaren Spulen und die zweiten planaren Spulen unabhängig voneinander zu übertragen. Als unabhängig übertragen wird dabei insbesondere angesehen, dass ein Übersprechen zwischen den beiden Signalen nach der Übertragung durch die erfindungsgemäße Übertragungsvorrichtung kleiner als -6 dB, -12 dB, -18 dB oder -40 dB ist. Wie diese unabhängige Übertragung der Signale erreicht werden kann, ist näher zu den verschiedenen Ausführungsformen in den Unteransprüchen erläutert.

Auf vorteilhafte Weise ermöglicht die induktive Kopplung glatte und pflegeleichte Oberflächen der Koppelelemente, die leicht gesäubert und sterilisiert werden können.

Ein erfindungsgemäßer Magnetresonanztomograph weist eine Lokalspule und eine erfindungsgemäße Übertragungsvorrichtung auf. Dabei steht die Lokalspule über die Übertragungsvorrichtung mit dem Magnetresonanzvorrichtung in Signalverbindung. Die Signalverbindung ist ausgelegt, mindestens zwei unabhängige Signale mit der Übertragungsvorrichtung zu übertragen, beispielsweise die Signale von zwei Antennenspulen der Lokalspule oder das Signal einer Antennenspule und einen Referenztakt bzw. Referenzsignal.

Der erfindungsgemäße Magnetresonanztomograph teilt die Vorteile der erfindungsgemäßen Lokalspule.

Weitere vorteilhafte Ausführungsformen sind zu den Unteransprüchen angegeben.

In einer denkbaren Ausführungsform der erfindungsgemäßen Übertragungsvorrichtung unterscheiden sich das erste Signal und das zweite Signal in der Frequenz. Darunter ist zu verstehen, dass die beiden Signale im Frequenzspektrum disjunkte Frequenzbereiche einnehmen. Mit anderen Worten, in einem Frequenzbereich des einen Signals ist der Pegel des anderen Signals um mehr als 20 dB, 40 dB oder 60 dB gedämpft.

Die Übertragungsvorrichtung ist dabei für eine Übertragung über die ersten planaren Spulen frequenzselektiv für das erste Signal ausgelegt und für eine Übertragung über die zweiten planaren Spulen frequenzselektiv für das zweite Signal. Als frequenzselektiv wird der Übertragungsweg dabei angesehen, wenn beispielsweise eine Dämpfung für einen Frequenzanteil außerhalb des Frequenzbereichs des ersten Signals größer als 12 dB, 18 dB oder 40 dB ist, während eine Welligkeit der Übertragungskennlinie in dem Frequenzbereich des ersten Signals kleiner als 5 dB, 1 dB oder 0,1 dB ist. Dies kann beispielsweise erreicht werden, indem ein Bandpass für den Frequenzbereich des ersten Signals mit den genannten Eigenschaften in dem Übertragungsweg des ersten Signals angeordnet ist. Gleiches gilt entsprechend für den Übertragungsweg des zweiten Signals über die zweiten planaren Spulen. Es ist aber auch denkbar, dass bei lediglich zwei unabhängigen zu übertragenden Signalen die Frequenzselektivität durch einen Hochpass und einen Tiefpass in den Übertragungswegen erzielt wird, wobei die Übergangsfrequenz des Hochpasses bzw. Tiefpasses im Spektrum zwischen den Frequenzbereichen des ersten Signals und des zweiten Signals ausgelegt ist.

Auf vorteilhafte Weise können durch die unterschiedliche Frequenzselektivität der Übertragungswege über die ersten planaren Spulen und die zweiten planaren Spulen zwei unterschiedliche Signale unabhängig voneinander übertragen werden, auch wenn die ersten planaren Spulen nicht von den zweiten planaren Spulen räumlich entkoppelt sind.

In einer möglichen Ausführungsform der erfindungsgemäßen Übertragungsvorrichtung überlappen die erste planare Spule und die zweite planare Spule in dem ersten Koppelelement vollständig. Als vollständig überlappen wird dabei angesehen, wenn die Projektion der flächenmäßig kleineren planaren Spule entlang der bereits definierten Flächennormale zu mehr als 80%, 95% oder 99% innerhalb der Fläche der flächenmäßig größeren planaren Spule liegt.

Auf vorteilhafte Weise ist es durch die Signaltrennung über die Frequenzselektivität möglich, erste und zweite planare Spulen platzsparend unmittelbar übereinander entlang der Flächennormale anzuordnen.

In einer anderen denkbaren Ausführungsform der erfindungsgemäßen Übertragungsvorrichtung weisen in einem Koppelelement eine erste benachbarte planare Spule und eine zweite benachbarte planare Spule eine überlappende Fläche derart auf, dass die erste planare Spule induktiv von der zweiten planaren Spule entkoppelt ist.

Als benachbart werden dabei die Spulen bezeichnet, wenn deren Projektion auf eine Ebene parallel zur Erstreckung einer der Spulen so zu liegen kommen, dass keine Projektion einer weiteren Spule auf diese Ebene dazwischen zu liegen kommt. Als überlappende Flächen werden dabei die Teile der Flächen der Spulen bezeichnet, deren Projektion die Schnittmenge der Projektionen der beiden planaren Spulen bildet.

Eine induktive Entkopplung wird erzielt, wenn ein Stromfluss durch die zweite planare Spule über den erzeugten magnetischen Fluss durch die überlappende Fläche in der ersten planaren Spule induzierter Strom gerade einem durch den magnetischen Fluss in der verbleibenden, nicht überlappenden Fläche der ersten planaren Spule induzierten Strom entspricht, da sich diese dann aufgrund des unterschiedlichen Vorzeichens gerade aufheben. Als induktiv entkoppelt wird es auch angesehen, wenn sich die beiden induzierten Ströme bis auf weniger als 5%, 2 % oder 1% im Betrag entsprechen.

Auf vorteilhafte Weise ermöglicht es die induktive Entkopplung der ersten planaren Spule von der zweiten planaren Spule, auch zwei unterschiedliche Signale im gleichen Frequenzbereich unabhängig voneinander induktiv zu übertragen. Durch eine Anordnung einer Vielzahl von in der gleichen Weise induktiv entkoppelter planarer Spulen in einer Ebene der Koppelelemente ermöglicht es so beispielsweise alle Kanäle einer Spulenmatrix parallel zu übertragen.

In einer möglichen Ausführungsform der erfindungsgemäßen Übertragungsvorrichtung sind die planaren Spulen eines Koppelelements als Leiterbahnen in einer Leiterplatte ausgeführt. Denkbar ist auch die Verwendung von flexiblen Leiterplatten.

Auf vorteilhafte Weise ermöglicht eine Leiterplatte eine robuste und platzsparende Bereitstellung von planaren Spulen

In einer denkbaren Ausführungsform der erfindungsgemäßen Übertragungsvorrichtung sind die erste planare Spule und die zweite planare Spule in unterschiedlichen Lagen einer mehrlagigen Leiterplatte ausgeführt. Dabei ist es denkbar, dass die planaren Spulen in den unterschiedlichen Lagen derart angeordnet sind, dass sie in einer Richtung senkrecht zur Oberfläche der Leiterplatte bzw. senkrecht zu den Lagen der Leiterplatte ganz oder teilweise überlappen.

Auf vorteilhafte Weise können in einer mehrlagigen Leiterplatte planare Spulen auch gestapelt werden, sei es, um durch einen Überlapp eine induktive Entkopplung bereitzustellen oder um sie zur Platzersparnis zu stapeln.

In einer möglichen Ausführungsform der erfindungsgemäßen Übertragungsvorrichtung sind die erste planare Spule und die zweite planare Spule ausgelegt, unabhängig voneinander und parallel ein erstes Signal und ein zweites Signal zu übertragen, wobei sich das erste Signal und das zweite Signal in Amplitude, Phase und/oder Frequenz voneinander unterscheiden. Unterschiedliche Möglichkeiten für die unabhängige Übertragung sind bereits zu den vorangehenden Unteransprüchen erläutert.

Auf vorteilhafte Weise kann durch das Übertragen mehrerer unabhängiger Signale über planare Spulen eines Koppelelements die Anzahl der Koppelelemente reduziert werden.

In einer denkbaren Ausführungsform der erfindungsgemäßen Übertragungsvorrichtung stehen bei in der vorbestimmten Relativposition zueinander positioniertem erstem Koppelelement und zweitem Koppelelement die Mehrzahl an planaren Spulen in erstem Koppelelement und zweitem Koppelelement sich jeweils paarweise gegenüber. Mit anderen Worten, die erste planare Spule in dem ersten Koppelelement und die erste planare Spule in dem zweiten Koppelelement sind entlang einer Flächennormalen der planaren Spulen so angeordnet, dass eine Projektion der ersten planaren Spule des ersten Koppelelements entlang der Flächennormalen im Wesentlichen deckungsgleich mit der ersten Spule im zweiten Koppelelement ist. Mit anderen Worten ist die Schnittmenge von Projektion und Spule maximal oder zumindest größer als 80%, 90% oder 95% der maximal möglichen Schnittmenge. Gleiches gilt für die zweiten planaren Spulen in den Koppelelementen. Der Abstand entlang der Flächennormale ist dabei möglichst gering, soweit es durch die Form der Koppelelemente möglich ist. Vorzugsweise ist der der ersten bzw. zweiten planaren Spulen Abstand entlang der Flächennormale kleiner als 10 mm, 5 mm, 2 mm oder 1 mm.

Durch die Anordnung paarweise gegenüber wird das durch Induktion übertragene Signal maximiert.

In einer möglichen Ausführungsform der erfindungsgemäßen Übertragungsvorrichtung ist eine Übertragungsbandbreite der Übertragungsvorrichtung eines Signals über eine erste planare Spule des ersten Koppelelements und eine damit in der vorbestimmten Relativposition induktiv gekoppelte erste planaren Spule des zweiten Koppelelements größer oder gleich einer Bandbreite eines Magnetresonanzsignals. Die gewünschte Bandbreite kann dabei über verschiedene Parameter verändert werden. Denkbar sind Resonanzfrequenzen der beteiligten planaren Spulen, die durch Eigenkapazität und mit an die planaren Spulen verbundene externe Kapazitäten und Induktivitäten beeinflusst werden können. Eine Kopplung beider Spulen führt dabei zu einer Aufspaltung und Verbreiterung. Denkbar sind auch unterschiedliche Belastungen der Spulen, die ebenfalls zu einer Verbreiterung der Bandbreite führen können. Weiterhin kann eine Anpassung bzw. gezielte Fehlanpassung von an die Spulen angeschlossenen Schaltkreise an die Eigenimpedanz der planaren Spule die Bandbreite verändern.

Auf vorteilhafte Weise kann eine erfindungsgemäße Anpassung der übertragenen Bandbreite eine vollständige und unverzerrte Übertragung der Magnetresonanzsignale sicherstellen.

In einer denkbaren Ausführungsform der erfindungsgemäßen Magnetresonanzvorrichtung weist die Lokalspule eine erste Antennenspule und eine zweite Antennenspule auf. Die Antennenspulen sind dabei ausgelegt, voneinander unabhängige Signale für die Bilderfassung zuliefern, insbesondere werden die Signale der beiden Antennenspulen nicht bereits in der Lokalspule zu einem Ausgangssignal kombiniert. Die Magnetresonanzvorrichtung ist ausgelegt, ein Magnetresonanzsignal der ersten Antennenspule über die ersten planaren Spulen zu übertragen und ein Magnetresonanzsignal der zweiten Antennenspule über die zweiten planaren Antennenspulen. Dabei ist es auch denkbar, dass die Magnetresonanzsignale vor der Übertragung vorverarbeitet werden, beispielsweise verstärkt, gefiltert, in der Frequenz umgesetzt oder digitalisiert.

Auf vorteilhafte Weise ist die erfindungsgemäße Magnetresonanzvorrichtung in der Lage über das erste Koppelelement und das zweite Koppelelement auch eine Mehrzahl von Signalen einer Lokalspulenmatrix zu übertragen.

In einer möglichen Ausführungsform der erfindungsgemäßen Magnetresonanzvorrichtung weist das erste Koppelelement und das zweite Koppelelement einen oder mehrere elektrische Kontakte zur ohmschen Übertragung von elektrischen Signalen auf. Dies können beispielsweise Kontaktflächen auf der einen Seite in dem ersten Koppelelement und Federn oder Stifte auf der anderen Seite in dem zweiten Koppelelement sein. Es ist dabei auch denkbar, dass die elektrischen Kontakte als mechanische Fixierungselemente zum Fixieren des ersten Koppelelements an dem zweiten Koppelelement dienen. Vorzugsweise sind dabei insbesondere die elektrischen Kontakte, die mit dem Patienten in Kontakt kommen können, möglichst eben und leicht zu reinigen. Insbesondere kann es sich bei den elektrischen Signalen auch um eine Energieversorgung der Lokalspule handeln.

Auf vorteilhafte Weise ermöglichen ohmsche bzw. galvanische Kontakte und Verbindungen eine einfachere und leistungsfähigere Versorgung mit elektrischer Energie, wobei im Gegensatz zu Hochfrequenzverbindungen die Kontakte auf Robustheit und einfache Reinigung optimiert werden können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen mit einer erfindungsgemäßen Übertragungsvorrichtung;
- Fig. 2: eine schematische Darstellung einer Ausführungsform einer erfindungsgemäßen Übertragungsvorrichtung;
- Fig. 3: eine schematische Darstellung einer Leiterplatte eines Koppelelements einer erfindungsgemäßen Übertragungsvorrichtung im Querschnitt;
- Fig. 4: eine schematische Darstellung einer Leiterplatte eines Koppelelements einer erfindungsgemäßen Übertragungsvorrichtung in Aufsicht;
- Fig. 5: eine schematische Darstellung einer Ausführungsform einer erfindungsgemäßen Übertragungsvorrichtung;
- Fig. 6: eine schematische Darstellung einer Leiterplatte eines Koppelelements einer erfindungsgemäßen Übertragungsvorrichtung in Aufsicht.

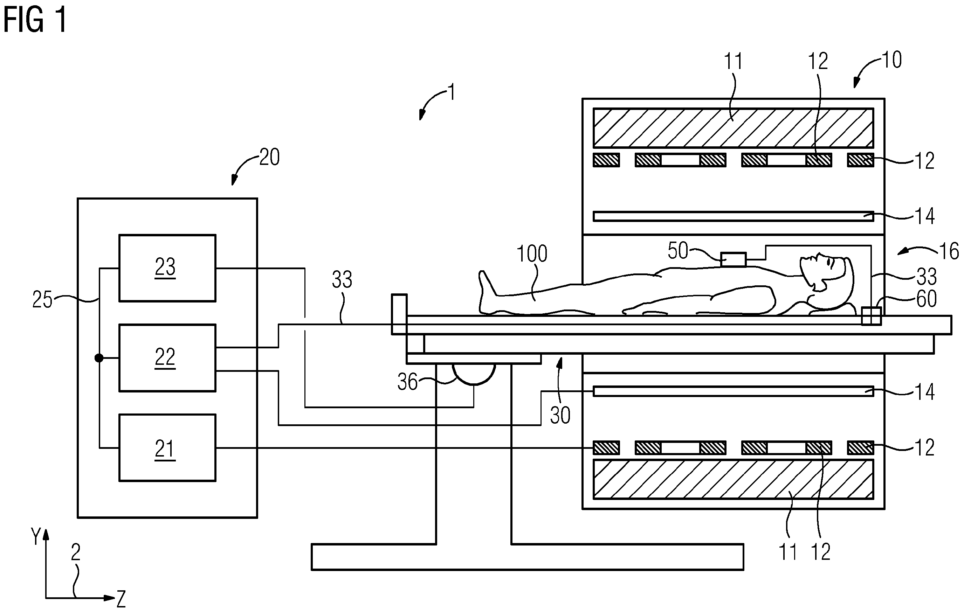

Fig. 1 zeigt eine schematische Darstellung einer Ausführungsform eines erfindungsgemäßen Magnetresonanztomographen 1 mit einer erfindungsgemäßen Übertragungsvorrichtung 60.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Magnetfeldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Zum Empfang des Magnetresonanzsignals ist eine Lokalspule 50 auf dem Patienten 100 im Patiententunnel 16 angeordnet, um Magnetresonanzsignale aus einem Untersuchungsbereich in unmittelbarer Nähe mit möglichst großem Rauschabstand zu erfassen. Die Lokalspule 50 ist über eine Anschlussleitung 33 mit einem Empfänger in der Hochfrequenzeinheit 22 in Signalverbindung. Da die Lokalspule je nach Art der Untersuchung gewechselt werden muss, ist die Verbindung lösbar über die erfindungsgemäße Koppelvorrichtung 60 geführt. In der dargestellten Ausführungsform ist die Koppelvorrichtung 50 mit einem zweiten Koppelelement 62 als Teil der Patientenliege 30 ausgeführt. Es ist aber auch denkbar, dass eine erfindungsgemäße Koppelvorrichtung 60 frei in einem Abschnitt der Anschlussleitung 33 angeordnet ist oder auch mit einem Koppelelement als Teil der Lokalspule 50.

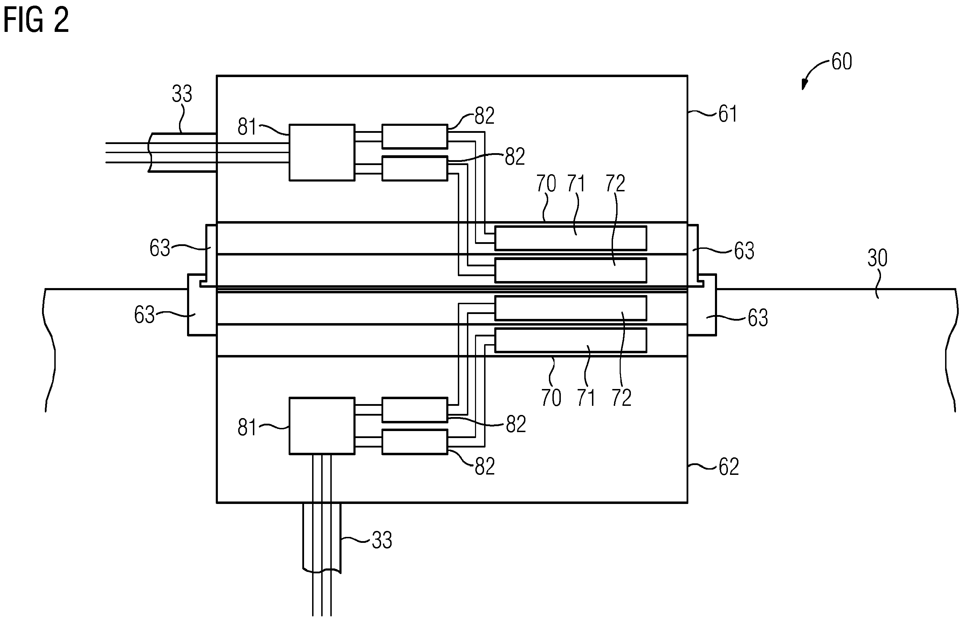

Fig. 2 zeigt eine schematische Darstellung einer Ausführungsform einer erfindungsgemäßen Übertragungsvorrichtung 60 im Detail. Die Übertragungsvorrichtung 60 weist zwei lösbar verbindbare Koppelelemente 61, 62 auf, das erste Koppelelement 61 und das zweite Koppelelement 62. Das erste Koppelelement 61 und das zweite Koppelelement 62 weisen korrespondierende Fixierelemente 63 auf, mit der das erste Koppelelement 61 und das zweite Koppelelement 62 lösbar in einer vorbestimmten Relativposition fixiert werden können. Denkbar sind beispielsweise Steck- oder Rastelemente, Haken, Federn oder Stifte, mit denen die beiden Koppelelemente verbunden werden können. Denkbar sind auch eine Fixierung durch ein Dichtmittel und eine Absaugvorrichtung zum Erzeugen eines Unterdrucks. Außerhalb des Patiententunnels 16 im Abstand zu dem Feldmagneten wären auch Magnete denkbar als Fixierelemente 63.

Vorzugsweise weist ein Koppelelement 61, 62 auch ein Gehäuse oder einen Verguss zum Schutz vor Verschmutzung oder Berührung auf. In der Fig. 2 ist das zweite Koppelelement 62 als Teil des Patientenliege 30 ausgeführt und kann somit auf ein eigenes Gehäuse verzichten, weil es in die Patientenliege 30 eingebettet ist.

Das erste Koppelelement 61 und das zweite Koppelelement 62 weisen jeweils eine erste planare Spule 71 und eine zweite planare Spule 72 auf. In den Ausführungsformen der Fig. 2 bis 6 sind die planaren Spulen 71, 72 als Leiterbahnen auf bzw. in einer Leiterplatte 70 ausgeführt. Denkbar sind jedoch auch aus Draht gewickelte Spulen. Die Leiterplatte 70 bildet vorzugsweise auch eine äußere Oberfläche des ersten Koppelelements 61 und/oder des zweiten Koppelelements 62, sodass der Abstand zwischen ersten planaren Spulen 71 und zweiten planaren Spulen 72 möglichst geringgehalten werden kann, wenn die Koppelelemente 61, 62 in die vorbestimmte Relativposition gebracht werden.

In der in Fig. 2 dargestellten Ausführungsform sind die ersten planaren Spulen 71 und die zweiten planaren Spulen 72 in der vorbestimmten Relativposition übereinander entlang einer Flächennormalen zur Leiterplatte 70 bzw. zur Fläche der planaren Spulen angeordnet. Dabei sind die planaren Spulen 71, 72 lateral zur Flächennormalen vorzugsweise so angeordnet, dass eine möglichst große Überlappung der Flächen vorliegt. Mit anderen Worten, die Projektionen der planaren Spulen 71, 72 entlang der Flächennormale weisen eine möglichst große Schnittmenge auf. Bei identischen planaren Spulen 71, 72 ist das der Fall, wenn die Projektionen deckungsgleich sind. Durch die möglichst große Überlappung wird eine optimale Kopplung der planaren Spulen 71, 72 für die Signalübertragung erzielt.

Die zu übertragenden Signale werden über die Anschlussleitung 33 zu- bzw. abgeführt. Bevor das Signal der planaren Spule 71, 72 zugeführt wird, wird es zur Optimierung der Übertragung durch ein Anpassungsschaltkreis 81 geführt. Streuinduktivitäten, bedingt durch die planare Spule 71, 72 ohne Kern, und Gegeninduktivität der korrespondierenden planaren Spule 71, 72 in dem anderen Koppelelement sind hinderlich, da diese dazu führen, dass die Signalquelle eine hohe Spannung liefern muss, um den gewünschten Strom zu erzeugen. Um eine effiziente Übertragung zu ermöglichen, müssen Streu- und Gegeninduktivität "weggestimmt" werden, also von dem Anpassungsschaltkreis kompensiert werden.

In der Ausführungsform der Fig. 2 bis 4 sind sowohl die ersten planaren Spulen 71 als auch die zweiten planaren Spulen 72 entlang der Flächennormalen der Leiterplatte angeordnet, um mit möglichst geringem Platzbedarf eine Übertragung bereitzustellen. Um Signale über die ersten planaren Spulen 71 und die zweiten planaren Spulen 72 unabhängig übertragen zu können, ist wegen der fehlenden Entkopplung zwischen ersten planaren Spulen 71 und zweiten planaren Spulen 72 eine Trennung der Signale im Frequenzraum erforderlich. Für Magnetresonanzsignale ist dies zu erreichen, indem diese auf unterschiedliche Zwischenfrequenzen umgesetzt werden. Referenztakte oder andere Hilfssignale haben vorzugsweise bereits unterschiedliche Frequenzbereiche im Vergleich zu den Magnetresonanzsignalen. Um eine Trennung auch von unerwünschten Oberwellen oder Störsignalen zu erzielen, sind weiterhin im Signalpfad des Koppelelements Filter 82 vor die planaren Spulen vorgesehen. Das können Bandpassfilter mit disjunkten Durchlassbereichen sein oder auch Hoch- und Tiefpassfilter mit einer Übergangsfrequenz, die zwischen den Signalfrequenzen, die mit den ersten planaren Spulen 71 übertragen werden sollen, und den Signalfrequenzen, die mit den zweiten planaren Spulen 72 übertragen werden sollen. Das Filter 82 und/oder der Anpassungsschaltkreis 81 sind dabei vorzugsweise mit den planaren Spulen auf der Leiterplatte angeordnet, können aber auch separat ausgeführt sein.

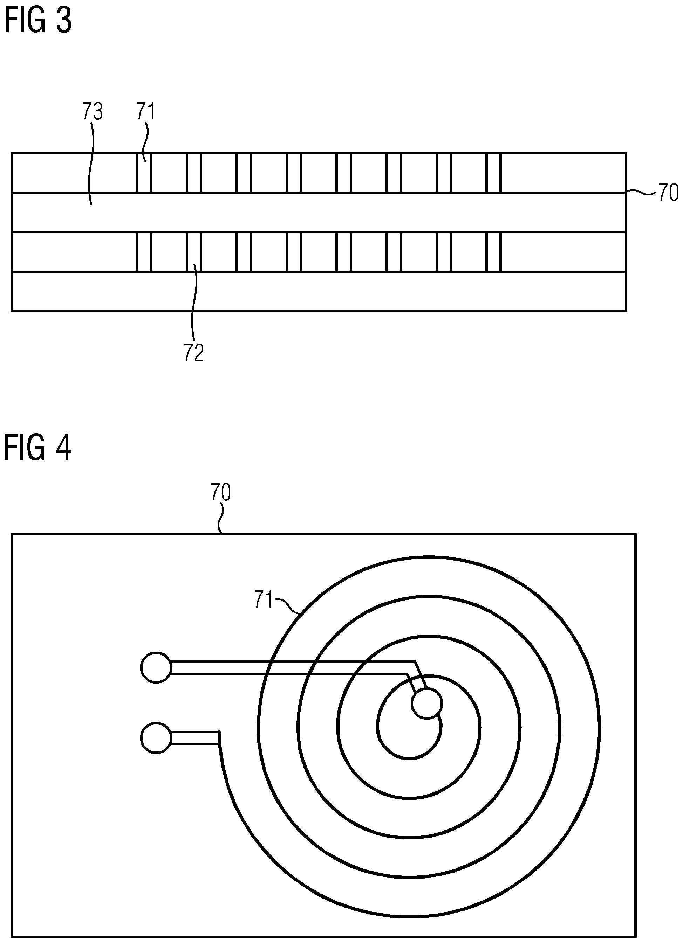

Fig. 3 zeigt einen Querschnitt einer Leiterplatte 70 aus Fig. 2 im Detail. Bei der Leiterplatte handelt es sich um eine mehrlagige Leiterplatte 70. Die erste planare Spule 71 und die zweite planare Spule 72 sind durch eine Isolierlage 73 voneinander getrennt unmittelbar übereinander angeordnet.

In der Aufsicht von Fig. 4 ist die erste planare Spule 71 auf der Leiterplatte 70 ersichtlich. Die zweite planare Spule 72 ist deckungsgleich darunter angeordnet und nicht sichtbar.

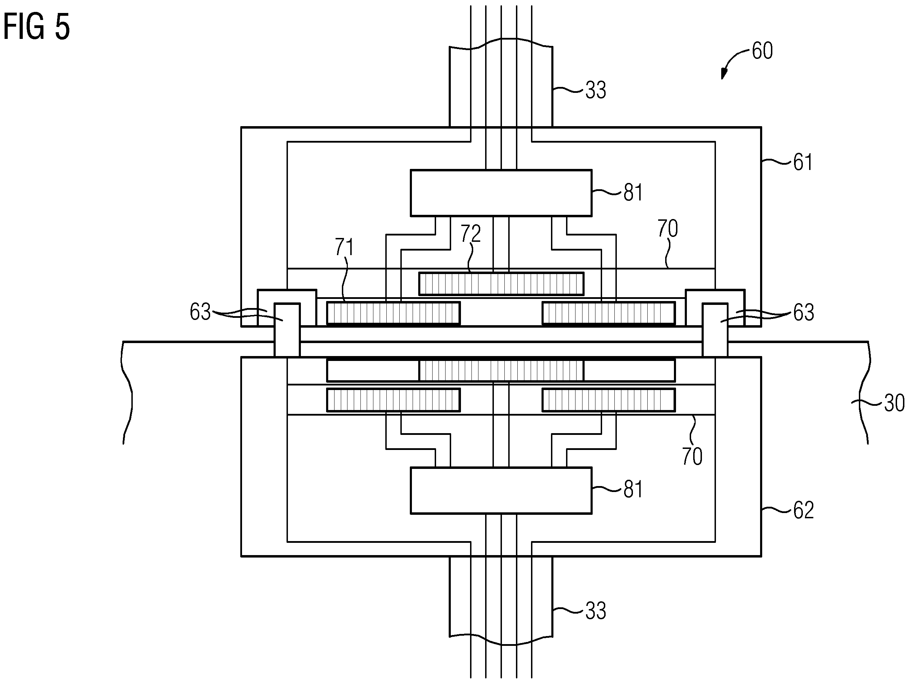

Fig. 5 zeigt eine andere Ausführungsform der erfindungsgemäßen Koppelvorrichtung 60. Gleiche Gegenstände sind mit gleichen Referenzzeichen bezeichnet.

Die Ausführungsform der Fig. 5 ist für die parallele unabhängige Übertragung von mehreren Signalen im gleichen Frequenzbereich vorgesehen. Um die ersten planaren Spulen 71 von den zweiten planaren Spulen 72 zu entkoppeln und damit die unabhängige parallele Signalübertragung sicherzustellen, sind die planaren Spulen 71, 72 in der Ebene der Leiterplatte 70 versetzt zueinander angeordnet, sodass benachbarte planare Spulen 71, 72 einander teilweise überlappen. Dabei ist der Überlapp so dimensioniert, dass ein durch einen Strom in einer lateral benachbarten planaren Spule 71, 72 erzeugtes Magnetfeld in dem überlappenden Bereich einen Strom induziert, der gerade den in den Restbereich der planaren Spule außerhalb des Überlapp induzierten Strom kompensiert.

Das Prinzip ist nicht nur auf zwei benachbarte Spulen anwenden, sondern ist auch auf eine Vielzahl von planaren Spulen 71,72 anwenden, die in einer Matrix angeordnet sind.

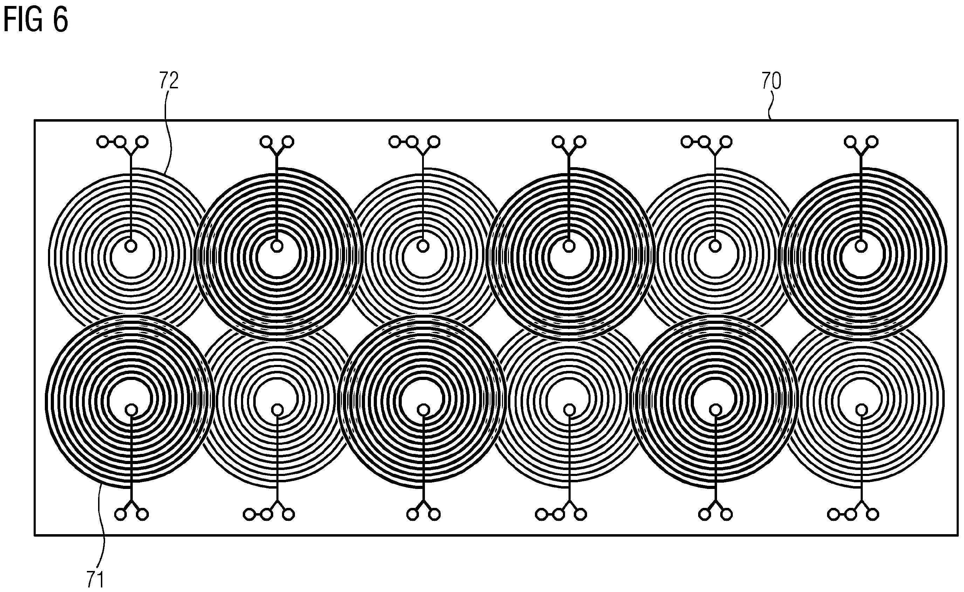

Fig. 6 zeigt eine entsprechende Anordnung von benachbarten, durch Überlappung voneinander entkoppelten planaren Spulen 71, 72. Die Überlappung lässt sich mit einer mehrlagigen Leiterplatte realisieren, wobei sich die planaren Spulen 71, 72 auf zwei unterschiedliche Leiterlagen verteilen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Übertragungsvorrichtung für einen Magnetresonanztomographen (1) , wobei die Übertragungsvorrichtung (60) eine Kopplungsvorrichtung mit einem ersten und einem zweiten lösbar in einer vorbestimmten Relativposition zueinander positionierbaren Koppelelementen (61, 62) aufweist, wobei das erste Koppelelement (61) und das zweite Koppelelement (62) jeweils eine erste planare Spule (71) und eine zweite planare Spule (72) aufweisen und in der vorbestimmten Relativposition jeweils die erste planare Spule (71) im ersten Koppelelement (61) mit der ersten planaren Spule (71) im zweiten Koppelelement (62) und die zweite planare Spule (72) im ersten Koppelelement (61) mit der zweiten planaren Spule (72) im zweiten Koppelelement (62) zur Übertragung von einem ersten Signal über die ersten planaren Spulen (71) und einem davon in Amplitude, Frequenz und/oder Phase unterschiedlichen zweiten Signal über die zweiten planaren Spulen (72) induktiv gekoppelt sind.

2. Übertragungsvorrichtung nach Anspruch 1, wobei das erste Signal und das zweite Signal sich in der Frequenz unterscheiden und die Übertragungsvorrichtung (60) für eine Übertragung über die ersten planaren Spulen (71) frequenzselektiv für das erste Signal ausgelegt ist und für eine Übertragung über die zweiten planaren Spulen (72) frequenzselektiv für das zweite Signal.

3. Übertragungsvorrichtung nach Anspruch 2, wobei die erste planare Spule (71) und die zweite planare Spule (72) in dem ersten Koppelelement (61) vollständig überlappen.

4. Übertragungsvorrichtung nach Anspruch 1, wobei in einem Koppelelement (61, 62) eine erste benachbarte planare Spule (71) und eine zweite benachbarte planare Spule (72) eine überlappende Fläche derart aufweisen, dass die erste planare Spule (71) induktiv von der zweiten planaren Spule (72) entkoppelt ist.

5. Übertragungsvorrichtung nach einem der Ansprüche 1 bis 4, wobei die planaren Spulen (71, 72) eines Koppelelements (61, 62) als Leiterbahnen in einer Leiterplatte (70) ausgeführt sind.

6. Übertragungsvorrichtung nach Anspruch 5, wobei die erste planare Spule (71) und die zweite planare Spule (72) in unterschiedlichen Lagen einer mehrlagigen Leiterplatte (70) ausgeführt sind.

7. Übertragungsvorrichtung nach einem der vorhergehenden Ansprüche, wobei die erste planare Spule (71) und die zweite planare Spule (72) ausgelegt sind, unabhängig voneinander und parallel ein erstes Signal und ein zweites Signal zu übertragen, wobei sich das erste Signal und das zweite Signal in Amplitude, Phase und/oder Frequenz voneinander unterscheiden.

8. Übertragungsvorrichtung nach einem der vorhergehenden Ansprüche, wobei bei in der vorbestimmten Relativposition zueinander positioniertem erstem Koppelelement (61) und zweitem Koppelelement (62) die Mehrzahl an planaren Spulen (71, 72) in erstem Koppelelement (61) und zweitem Koppelelement (62) sich jeweils paarweise gegenüberstehen.

9. Übertragungsvorrichtung nach einem der vorhergehenden Ansprüche, wobei eine Übertragungsbandbreite der Übertragungsvorrichtung (60) eines Signals über eine erste planare Spule (71) des ersten Koppelelements (61) und eine damit in der vorbestimmten Relativposition induktiv gekoppelte erste planaren Spule (71) des zweiten Koppelelements (62) größer oder gleich einer Bandbreite eines Magnetresonanzsignals ist.

10. Magnetresonanztomograph mit einer Lokalspule (50) und einer Übertragungsvorrichtung (60) nach einem der vorhergehenden Ansprüche, wobei die Lokalspule (50) über die Übertragungsvorrichtung (60) mit dem Magnetresonanzvorrichtung (1) in Signalverbindung steht.

11. Magnetresonanzvorrichtung nach Anspruch 10, wobei die Lokalspule (50) eine erste Antennenspule und eine zweite Antennenspule aufweist, wobei die Magnetresonanzvorrichtung (1) ausgelegt ist, ein Magnetresonanzsignal (1) der ersten Antennenspule über die ersten planaren Spulen (71) übertragen wird und ein Magnetresonanzsignal der zweiten Antennenspule über die zweiten planaren Spulen (72).

12. Magnetresonanzvorrichtung nach Anspruch 10 oder 11, wobei das erste Koppelelement (61) und das zweite Koppelelement (62) einen oder mehrere elektrische Kontakte zur ohmschen Übertragung von elektrischen Signalen aufweist.
